# EUROPEAN PATENT APPLICATION

(11) **EP 4 618 235 A1**
(43) Date of publication of application: **17.09.2025**
(21) Application number: 24894305.2
(22) Date of filing: 13.08.2024
(51) Int. Cl.: H01M 10/44, H02J 7/00, H01M 10/04, H01M 4/04, G01R 31/364

(54) **BATTERY CHARGING AND DISCHARGING SYSTEM AND CONTROL DEVICE THEREOF**

(30) Priority: 20.11.2023 KR 20230159987
(71) Applicant: LG Energy Solution, Ltd., Seoul 07335 (KR)
(72) Inventor: KIM, Myungki, Daejeon 34122 (KR)
(74) Representative: Goddar, Heinz J.
(86) International application number: PCT/KR2024/012060
(87) International publication number: WO 2025/110408

(57) **Abstract**

Disclosed is a battery charge and discharge system which include a cabinet; a plurality of charging and discharging units which are installed in an accommodation space formed in the cabinet; a power supply device that supplies power to the plurality of charging and discharging units; and a power transmission device that electrically connects the power supply device and the plurality of charging and discharging units. Here, the power supply device may simultaneously supply power to at least two charging and discharging units among the plurality of charging and discharging units through the power transmission device.

## Description

### [Technical Field]

This application claims priority to and the benefit of Korean Patent Application No.10-2023-0159987 filed in the Korean Intellectual Property Office on November 20, 2023 the entire contents of which are incorporated herein by reference.

The present invention relates to a battery charging and discharging system and a control apparatus thereof, and more particularly, to a battery charging and discharging system used in a battery activation process and a control apparatus thereof.

### [Background Art]

Secondary batteries, capable of recharging and reuse, can be used as an energy source for small devices such as mobile phones, tablet PCs and vacuum cleaners, and also used as an energy source for medium and large devices such as personal mobility, automobiles, and an energy storage system (ESS) for smart grids.

Secondary batteries may be applied to a system in a form of an assembly such as a battery module in which a plurality of battery cells is connected in series and parallel or a battery rack in which battery modules are connected in series and parallel according to system requirements.

Battery cells are manufactured through an assembly process and an activation process. Since battery cells are assembled in discharged state, the activation process must be performed after the battery cell assembly process so that the positive electrode active material is activated and a surface film (Solid Electrolyte Interface: SEI) can be formed on the negative electrode, allowing the cell to function as a battery. This activation process is called a formation process. The activation process can be performed by charging and discharging the battery cell multiple times according to a predefined charge and discharge profile.

A charge and discharge device for the activation process may include a tray in which batteries are accommodated, a probe plate located over the tray, a channel board that is electrically connected to each probe included in the probe plate and applies a charge and discharge current to the battery, and an actuator that raises and lowers the probe plate and the channel board. In general, a battery charge/discharge system for simultaneously charging and discharging multiple batteries using multiple charge and discharge devices is used to shorten the time for activation process.

In a typical battery charge/discharge system, a plurality of charging/discharging devices and a plurality of individual power supply devices for supplying power to the charging/discharging devices are included. Here, each of the charging/discharging devices is configured to receive power from a corresponding individual power supply device. Accordingly, the volume of a cabinet that accommodates the charging/discharging devices and the power supply devices can be increased, and the number of charging/discharging devices accommodated inside the cabinet needs to be reduced if the volume of the cabinet is limited.

### [Detailed Description of the Invention]

### [Technical Problem]

To obviate one or more problems of the related art, embodiments of the present disclosure provide a battery charge and discharge system that can be utilized in a battery activation process.

To obviate one or more problems of the related art, embodiments of the present disclosure also provide a control apparatus of the battery charge and discharge system.

To obviate one or more problems of the related art, embodiments of the present disclosure also provide a control method of the battery charge and discharge system.

### [Technical Solution]

In order to achieve the objective of the present disclosure, a battery charge and discharge system according to an embodiment of the present invention may include a cabinet; a plurality of charging and discharging units which are installed in an accommodation space formed in the cabinet; a power supply device that supplies power to the plurality of charging and discharging units; and a power transmission device that electrically connects the power supply device and the plurality of charging and discharging units. Here, the power supply device may simultaneously supply power to at least two charging and discharging units among the plurality of charging and discharging units through the power transmission device.

The power transmission device may electrically connect an output terminal of the power supply device and an input/output terminal of each of the plurality of charging and discharging units.

Here, the power transmission device may include a main power transmission member, one side of which is connected to an output terminal of the power supply device; and a plurality of sub power transmission members, one side of which is connected to the main power transmission member and the other side is connected to each of the input/output terminals of the charging/discharging units, respectively.

The charging/discharging units may be mounted in the cabinet in a stacked structure, the power supply device may be arranged on an upper or lower layer of the charging/discharging units. Here, the power transmission device may include a main busbar, one side of which is connected to the output terminal of the power supply device and the other side is formed to extend upward; and a plurality of sub busbars, one side of which is connected to the main busbar and the other side is extended horizontally and connected to each of the input/output terminals of the charging/discharging units, respectively.

The at least two of the plurality of charging/discharging units may be simultaneously charged according to the same charge profile or simultaneously discharged according to the same discharge profile.

The plurality of charge/discharge units may be classified into a first group and a second group, when the first group operates in charge mode, the second group operates in discharge mode, and when the first group operates in discharge mode, the second group operates in charge mode. Here, power discharged from a group operating in the discharge mode is supplied to a group operating in the charge mode through the power transmission device.

The power supply device may adjust power output to the power transmission device side in response to power discharged from the group operating in the discharge mode.

According to another embodiment of the present disclosure, a control apparatus of a battery charge/discharge system, including a plurality of charging/discharging units, a power supply device, and a power transmission device electrically connecting the power supply device and the plurality of charging/discharging units, may include at least one processor; and a memory configured to store at least one instruction executed by the at least one processor.

The at least one instruction may include an instruction to classify the plurality of
charging/discharging units into a first group and a second group; an instruction to set the first group to a charge mode and to set the second group to a discharge mode; and an instruction to control the charging/discharging units included in the first group to be charged with power simultaneously supplied from the power supply device through the power transmission device.

The instruction to control the
charging/discharging units to be charged may include an instruction to control the charging/discharging units included in the first group to be simultaneously charged according to the same charge profile.

The at least one instruction may further include an instruction to control the charging/discharging units included in the second group to be discharged simultaneously according to the same discharge profile.

The at least one instruction may further include an instruction to adjust the power output from the power supply device to the power transmission device in response to the power discharged from the second group.

The at least one instruction may further include an instruction to switch the first group to a discharge mode and to switch the second group to a charge mode when the charge process of the first group is completed and the discharge process of the second group is completed.

According to another embodiment of the present disclosure, a control method of a battery charge/discharge system, including a plurality of charging/discharging units, a power supply device, and a power transmission device electrically connecting the power supply device and the plurality of charging/discharging units, may include classifying the plurality of charging/discharging units into a first group and a second group; setting the first group to a charge mode and setting the second group to a discharge mode; and controlling the charging/discharging units included in the first group to be charged with power simultaneously supplied through the power transmission device from the power supply device.

The controlling the charging/discharging units to be charged may include controlling the
charging/discharging units included in the first group to be simultaneously charged according to the same charge profile.

The method may further include controlling the charging/discharging units included in the second group to be discharged simultaneously according to the same discharge profile.

The method may further include adjusting the power output from the power supply device to the power transmission device in response to the power discharged from the second group.

The method may further include switching the first group to a discharge mode and to switch the second group to a charge mode, when the charge process of the first group is completed and the discharge process of the second group is completed.

### [Advantageous Effects]

According to embodiments of the present disclosure, space efficiency of the battery charge/discharge system is improved and the number of charging/discharging units accommodated inside the system can be increased.

In addition, power efficiency of the battery charge/discharge system can be improved according to embodiments of the present disclosure.

### [Brief Description of the Drawings]

FIG. 1 is a block diagram of a battery charge/discharge system according to embodiments of the present invention.
FIG. 2 is a front cross-sectional view of a charging/discharging unit according to embodiments of the present invention.
FIG. 3 shows an arrangement structure of a battery charge/discharge system according to embodiments of the present invention.
FIG. 4 is a reference diagram for explaining operation of the battery charge/discharge system in a first mode according to embodiments of the present invention.
FIG. 5 is a reference diagram for explaining operation of the battery charge/discharge system in a second mode according to embodiments of the present invention.
FIG. 6 is an operational flowchart of a control method of a battery charge/discharge system according to embodiments of the present invention.
FIG. 7 is a block diagram of a control apparatus of a battery charge/discharge system according to embodiments of the present invention.

100: cabinet
200: charging/discharging units
300: power supply device
400: power transmission device
500: control apparatus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, exemplary embodiments of the present invention will be described in detail with reference to the accompanying drawings.

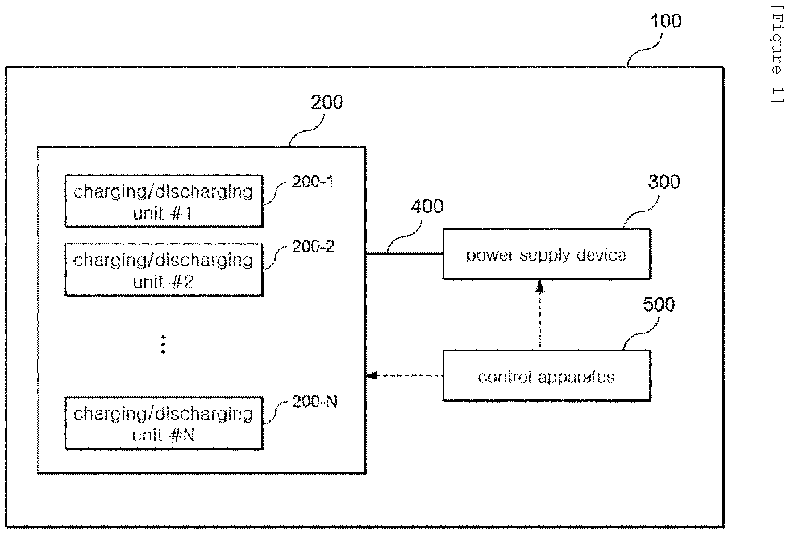

FIG. 1 is a block diagram of a battery charge/discharge system according to embodiments of the present invention.

The battery charge/discharge system according to embodiments of the present invention may include a cabinet 100, a plurality of charging/discharging units 200, a power supply device 300, a power transmission device 400, and a control apparatus 500.

The cabinet 100 may be a structure that accommodates the charging/discharging units 200, the power supply device 300, and the power transmission device 400. Here, the control apparatus 500 may be accommodated inside the cabinet 100 or may be arranged outside and connected to the charging/discharging units 200 and the power supply device 300.

The cabinet 100 may include one or more accommodation spaces in which the charging/discharging units 200 are installed. Here, the cabinet 100 may include a plurality of accommodation spaces formed in a multi-layer structure and the plurality of charging and discharging units 200 may be arranged in a stacked structure by being installed in each of the accommodation spaces.

The cabinet 100 may include one or more accommodation spaces in which a power supply device 300 and a control apparatus 500 are installed. Here, the accommodation space for the power supply device 300 and the control apparatus 500 may be provided in one or more of the upper and lower layers of the accommodation space for the charging and discharging units 200.

The charging and discharging unit may be electrically connected to a battery and perform charge and discharge process. Here, the battery charge and discharge system may include N charging and discharging units 200-1 to 200-N.

Each of the charging/discharging units 200-1 to 200-N may charge/discharge the batteries when multiple batteries are accommodated inside, thereby activating the batteries.

The power supply device 300 may supply power to the charging/discharging units 200. Here, the power supply device 300 may convert power supplied from the outside into a predetermined voltage and supply it to the charging/discharging units 200. The power supply device 300 may include at least one of an AC/DC inverter for converting AC voltage into DC voltage and a DC/DC converter for reducing the DC voltage.

The power transmission device 400 is a device that electrically connects the charging/discharging units 200 and the power supply device 300, and transmits power output from the power supply device 300 to the charging/discharging units 200. Here, the power transmission device 400 may be configured to include at least one of a cable and a busbar.

The power transmission device 400 may electrically connect the output terminal of the power supply device 300 and the input/output terminals of each of the charging/discharging units 200-1 to 200-N and may transmit the DC voltage output from the power supply device 300 to each of the charging/discharging units 200-1 to 200-**N.**

The power transmission device 400 may include at least one circuit breaker arranged on the power transmission path.

The power supply device 300 may simultaneously supply power to at least two charging/discharging units among the charging/discharging units 200 through the power transmission device 400. In other words, the input/output terminals of the plurality of charging/discharging units and the output terminal of the power supply device 300 are connected to a node having the same potential, so that the power output from the power supply device 300 can be supplied to the plurality of charging/discharging units in an integrated manner.

The control apparatus 500 may control the operation of the charging/discharging units 200. Here, the control apparatus 500 may control the operation mode of each of the charging/discharging units 200. For example, the control apparatus 500 may control at least some of the charging/discharging units 200-1 to 200-N to operate in a charge mode and control the remaining some to operate in a discharge mode.

The control apparatus 500 may control the charging/discharging units so that the battery is charged/discharged according to a predefined charge/discharge profile. Here, the charge/discharge profile may include a current value, a voltage value, and a power value per unit time.

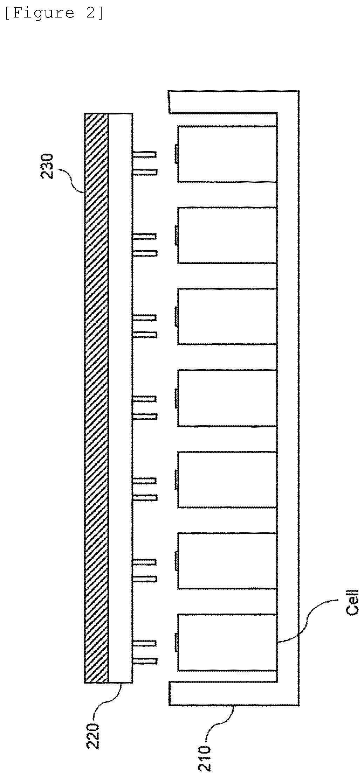

FIG. 2 is a front cross-sectional view of a charging/discharging unit according to embodiments of the present invention.

Referring to FIG. 2, the charging/discharging unit may include a tray 210, a probe plate 220, and a channel board 230.

The tray 210 is a structure that accommodates a plurality of battery cells. Here, the tray 210 with a plurality of battery cells accommodated therein may be transported through a transport device and may be settled inside the charging/discharging unit. In addition, when the charging/discharge process by the charging/discharging unit is completed, the tray 210 may be discharged to the outside through the transport device and transported to equipment for another process.

The probe plate 220 may be arranged over the tray 210 and may include a plurality of positive contact pins and negative contact pins. Here, the probe plate 220 may include a number of positive contact pins and negative contact pins corresponding to the number of battery cells.

The positive contact pin and the negative contact pin are arranged at positions corresponding to the positive and negative poles of the battery cell, respectively, and the probe plate 220 may be lowered to electrically contact the positive and negative poles of the battery cell when the charge and discharge process is in progress.

Meanwhile, the probe plate 220 illustrated in FIG. 2 is a single plate including both the positive contact pin and the negative contact pin. However, unlike that illustrated in FIG. 2, the probe plate may be implemented as a structure separated into a positive probe plate arranged over the tray 210 and a negative probe plate arranged under the tray 210. In this case, when the tray 210 is settled inside the charging and discharging unit through the transport device, the negative contact pin of the negative probe plate and the negative pole of the battery cell come into contact, and then, the positive contact pin and the positive pole of the battery cell may come into contact when the positive probe plate is lowered.

The channel board 230 may be electrically connected to the positive contact pin and the negative contact pin included in the probe plate 210 to apply current for charging and discharging the battery. Here, the channel board 230 may be operated by receiving power through the power supply device 300 described in FIG. 1.

The channel board 230 may include a distribution circuit for distributing the supplied power to each battery cell so that each battery cell can be charged and discharged according to a predefined charge and discharge profile.

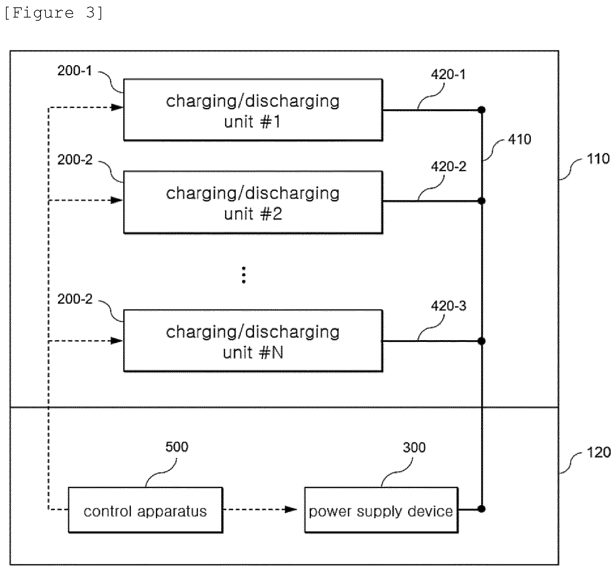

FIG. 3 shows an arrangement structure of a battery charge/discharge system according to embodiments of the present invention.

The cabinet 100 may include an upper frame 110 and a lower frame 120.

The upper frame 110 may include a plurality of accommodation spaces formed in a multi-layer structure and the charging/discharging units 200-1 to 200-N may be placed in each of the accommodation spaces and arranged in a stacked structure.

The lower frame 120 may be arranged under the upper frame 110, and a power supply device 300 and a control apparatus 500 may be accommodated therein.

Meanwhile, unlike as shown in FIG. 3, the charging/discharging units 200-1 to 200-N may be arranged in the lower frame 120 and the power supply device 300 and the control apparatus 500 may be arranged in the upper frame 110.

Each of the charging/discharging units 200-1 to 200-N may charge/discharge the batteries when a plurality of batteries are accommodated inside, thereby activating the batteries.

The power supply device 300 may convert power supplied from the outside into a predetermined voltage and supply the voltage to a channel board of each charging/discharging unit 200. Here, the power supply device 300 may be electrically connected to the channel board of each charging/discharging unit 200-1 to 200-N through a power transmission device.

The power transmission device may include a main power transmission member 410 and a plurality of sub-power transmission members 420-1 to 420-N. Here, one side of the main power transmission member 410 may be connected to an output terminal of the power supply device 300. In addition, each of the sub power transmission members 420-1 to 420-N may have one side connected to the main power transmission member 410 and the other side connected to the channel board of the corresponding charging/discharging unit 200-1 to 200-N. In other words, as illustrated in FIG. 3, the input/output terminals of the charging/discharging units 200-1 to 200-N and the output terminal of the power supply device 300 may be connected to a node having the same potential. Accordingly, the power output from the power supply device 300 may be integrally supplied to the channel board of each of the plurality of
charging/discharging units 200-1 to 200-N.

Each of the sub power transmission members 420-1 to 420-N may include one or more circuit breakers arranged on a power transmission path. The circuit breakers may be turned on/off controlled via the control apparatus 500.

In an embodiment, the power transmission device may include a main power busbar and a plurality of sub-busbars. In other words, each of the main power transmission member 410 and the plurality of sub-power transmission members 420-1 to 420-N may be implemented as a busbar.

Here, the main busbar may be formed such that one side is connected to the output terminal of the power supply device 300 and the other side extends upward. In addition, each of the sub-busbars may be formed such that one side is connected to the main busbar and the other side extends horizontally and may be connected to the channel board of the corresponding charging/discharging unit 200-1 to 200-N. In other words, the input/output terminals of the charging/discharging units 200-1 to 200-N and the output terminal of the power supply device 300 may be connected to a busbar having the same potential. Accordingly, power output from the power supply device 300 may be integrally supplied to each channel board through the main busbar and the sub-busbars.

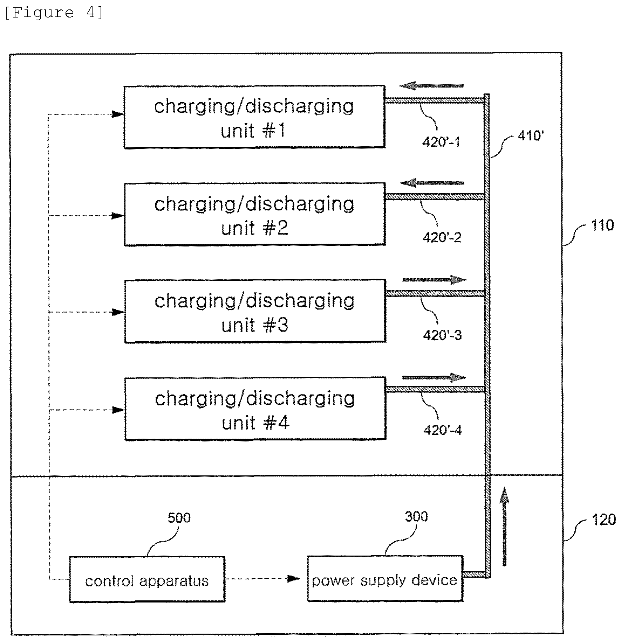

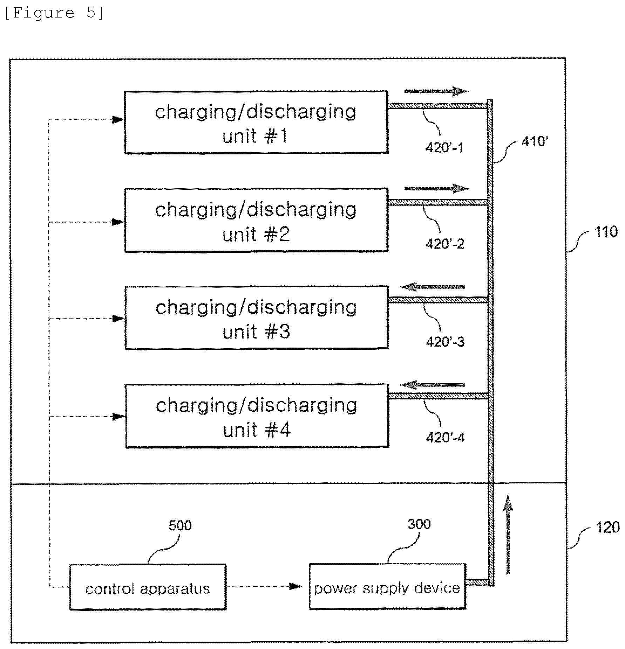

FIG. 4 is a reference diagram for explaining operation of the battery charge/discharge system in a first mode according to embodiments of the present invention and FIG. 5 is a reference diagram for explaining operation of the battery charge/discharge system in a second mode according to embodiments of the present invention.

Meanwhile, FIGS. 4 and 5 illustrate a battery charge/discharge system in which four charging/discharging units #1 to #4 are accommodated in a stacked structure. Here, the structure of the battery charge/discharge system described in FIGS. 4 and 5 is an example for explaining the operation of the battery charge/discharge system according to embodiments of the present invention, and thus, the scope of the present invention is not limited to this structure.

The power transmission device may include a main busbar 410' and a plurality of sub busbars 420'-1 to 420'-4. Here, the main busbar 410' may be formed such that one side is connected to the output terminal of the power supply device 300 and the other side extends upward. In addition, each of the sub busbars 420'-1 to 420'-4 may have one side connected to the main busbar 410' and the other side extended in a horizontal direction and connected to the channel board of the corresponding charging/discharging unit.

At least two of the plurality of charging/discharging units may be simultaneously charged according to the same charge profile or simultaneously discharged according to the same discharge profile. For example, charging/discharging unit #1 and #2 may be simultaneously charged according to the same charge profile and charging/discharging unit #3 and #4 may be simultaneously discharged according to the same discharge profile.

The plurality of charging/discharging units may be classified into a first group and a second group. Here, when the first group operates in a charge mode, the second group may operate in a discharge mode, whereas when the first group operates in a discharge mode, the second group may operate in a charge mode.

For example, charging/discharging units #1 and #2 may be defined as the first group and
charging/discharging units #3 and #4 may be defined as the second group. Here, when the battery charge/discharge system operates in the first mode, as shown in FIG. 4, the first group (charging/discharging units #1 and #2) may operate in the charge mode and the second group (charging/discharging units #3 and #4) may operate in the discharge mode. In addition, when the battery charge/discharge system operates in the second mode, as shown in FIG. 5, the first group (charging/discharging units #1 and #2) may operate in the discharge mode and the second group (charging/discharging units #3 and #4) may operate in the charge mode. Here, the operation of determining the first group or the second group and the switching between the first mode and the second mode may be performed by the control apparatus 500.

Referring to FIGS. 4 and 5, power discharged from a group operating in a discharge mode may be supplied to a group operating in a charge mode via a power transmission device. For example, in the case of the first mode, as illustrated in FIG. 4, discharge power output from the second group (charging/discharging units #3 and #4) may be transmitted to the first group (charging/discharging units #1 and #2) via the sub busbars 420'-1 to 420'-4 and the main busbar 410'. For another example, in the case of the second mode, as illustrated in FIG. 5, discharged power output from the first group (charging/discharging units #1 and #2) may be transmitted to the second group (charging/discharging units #3 and #4) via the sub busbars 420'-1 to 420'-4 and the main busbar 410'.

Since the first group and the second group are set to different operation modes and the charge and discharge processes are performed simultaneously, the output power of the power supply device 300 can be reduced, so that the power efficiency of the battery charge and discharge system can be improved.

The power supply device 300 may adjust the power to be output to the power transmission device side in response to the power discharged from the group operating in the discharge mode. Specifically, when the number of charging and discharging units included in each of the first group and the second group is different, the power supply device 300 may adjust the output power based on the number of charging and discharging units included in the group operating in the discharge mode. For example, if the first group includes four charge/discharge units and the second group includes six charge/discharge units, when switching from the first mode (the first group - charge mode, the second group - discharge mode) to the second mode (the first group - discharge mode, the second group - charge mode), the power output from the power supply device 300 may increase in response to the decreased amount of power discharged toward the power transmission device. In contrast, when switching from the second mode to the first mode, the power output from the power supply device 300 may decrease in response to the increased amount of power discharged toward the power transmission device. Meanwhile, the control apparatus 500 may transmit a control signal for adjusting the output power amount to the power supply device 300 and the power supply device 300 may adjust the output power amount according to the control signal.

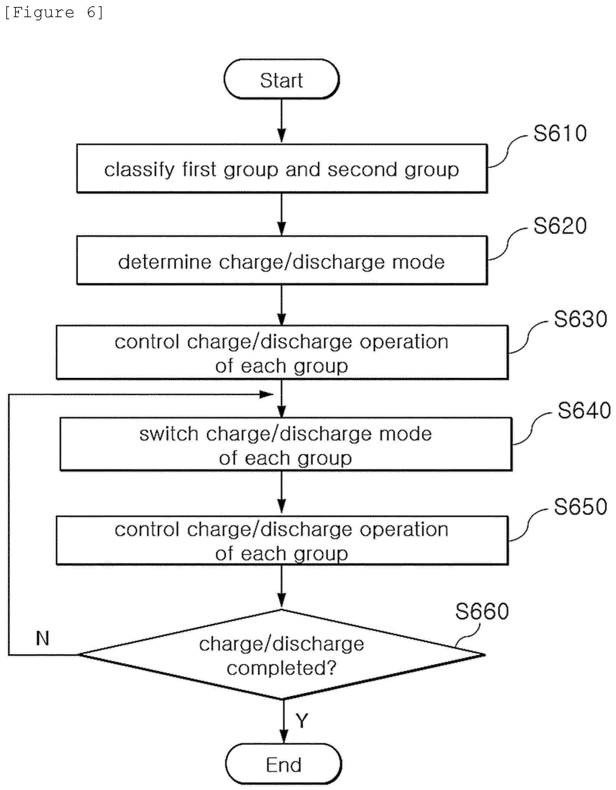

FIG. 6 is an operational flowchart of a control method of a battery charge/discharge system according to embodiments of the present invention. Meanwhile, the control method described below may be performed by a control apparatus included in the battery charge/discharge system.

The control apparatus may classify the charging/discharging units included in the battery charge/discharge system into a first group and a second group (a step S610).

The control apparatus may determine a charge/discharge mode for each of the groups (a step S620). For example, the control apparatus may set the first group to a charge mode and the second group to a discharge mode.

Thereafter, the control apparatus may control the operation of each group so that the charge/discharge process is performed according to the charge/discharge mode determined in the step S620 (a step S630).

Specifically, the control apparatus may control the charging/discharging units included in the first group to be simultaneously supplied with power from a power supply device through a power transmission device and charged. Here, the control apparatus may control the charging/discharging units included in the first group to be simultaneously charged according to the same charge profile.

In addition, the control apparatus may control the charging and discharging units included in the second group so that discharge process is performed simultaneously with the charge process of the first group. Here, the control apparatus may control the charging and discharging units included in the second group so that they are discharged simultaneously according to the same discharge profile.

The control apparatus may adjust the power of the power supply device output to the power transmission device side in response to the power discharged from the second group.

When the charge and discharge processes of the groups are completed, the control apparatus can switch the charge/discharge mode of each group (a step S640). Specifically, when the charge process of the first group is completed and the discharge process of the second group is completed, the control apparatus can switch the first group to the discharge mode and the second group to the charge mode.

Thereafter, the control apparatus may control the operation of each group so that the charge and discharge process is performed according to the charge and discharge mode switched in the step S640 (a step S650).

Specifically, the control apparatus may control the charging and discharging units included in the second group so that they are simultaneously supplied and charged with power from the power supply device through the power transmission device. Here, the control apparatus may control the charging and discharging units included in the second group to be simultaneously charged according to the same charge profile.

In addition, the control apparatus may control discharge process of the charging and discharging units included in the first group to be simultaneously performed with the charge process of the second group. Here, the control apparatus may control the charging and discharging units included in the first group to be simultaneously discharged according to the same discharge profile.

When the charge and discharge processes of the groups are completed, the control apparatus may check (a step S660) whether the charge and discharge processes have been performed for a predetermined target number of cycles. If the cumulative number of cycles is less than the target number of cycles (N of the step S660), the control apparatus may control the operation of each group to switch the charge and discharge modes of each group (the step S640) and to perform the charge and discharge process according to the switched charge and discharge mode (the step S650). If the cumulative number of cycles is equal to the target number of cycles (Y of the step S660), the control apparatus may terminate the charge and discharge process for battery activation and switch the battery charge and discharge system to a stop mode.

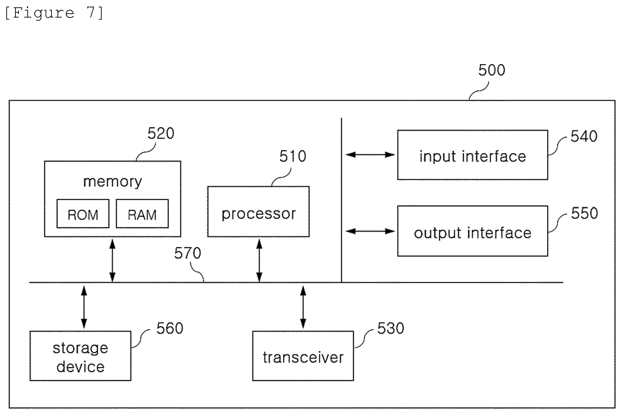

FIG. 7 is a block diagram of a control apparatus of a battery charge/discharge system according to embodiments of the present invention.

The control apparatus 500 according to embodiments of the present invention may be located in a battery charge/discharge system including a plurality of charging/discharging units, a power supply device, and a power transmission device that electrically connects the power supply device and the plurality of
charging/discharging units.

The control apparatus 500 may include at least one processor 510, a memory 520 that stores at least one instruction executed through the processor, and a transceiver 530 connected to a network to perform communication.

The at least one instruction may include an instruction to classify the plurality of
charging/discharging units into a first group and a second group; an instruction to set the first group to a charge mode and to set the second group to a discharge mode; and an instruction to control the charging/discharging units included in the first group to be charged with power simultaneously supplied from the power supply device through the power transmission device.

The instruction to control the
charging/discharging units to be charged may include an instruction to control the charging/discharging units included in the first group to be simultaneously charged according to the same charge profile.

The at least one instruction may further include an instruction to control the charging/discharging units included in the second group to be discharged simultaneously according to the same discharge profile.

The at least one instruction may further include an instruction to adjust the power output from the power supply device to the power transmission device in response to the power discharged from the second group.

The at least one instruction may further include an instruction to switch the first group to a discharge mode and to switch the second group to a charge mode when the charge process of the first group is completed and the discharge process of the second group is completed.

Meanwhile, the control apparatus 500 according to embodiments of the present invention may further include an input interface device 540, an output interface device 550, a storage device 560, etc. Respective components included in the control apparatus 500 may be connected by a bus 570 and can communicate with each other.

Here, the processor 510 may be a central processing unit (CPU), a graphics processing unit (GPU), or a dedicated processor on which methods according to embodiments of the present invention are performed. The memory (or storage unit) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the foregoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery charge and discharge system, comprising:
a cabinet;
a plurality of charging and discharging units which are installed in an accommodation space formed in the cabinet;
a power supply device that supplies power to the plurality of charging and discharging units; and
a power transmission device that electrically connects the power supply device and the plurality of charging and discharging units,
wherein the power supply device simultaneously supplies power to at least two charging and discharging units among the plurality of charging and discharging units through the power transmission device.

2. The battery charge and discharge system of claim 1, wherein the power transmission device electrically connects an output terminal of the power supply device and an input/output terminal of each of the plurality of charging and discharging units.

3. The battery charge and discharge system of claim 2, wherein the power transmission device includes:
a main power transmission member, one side of which is connected to an output terminal of the power supply device; and
a plurality of sub power transmission members, one side of which is connected to the main power transmission member and the other side is connected to each of the input/output terminals of the charging/discharging units, respectively.

4. The battery charge and discharge system of claim 1, wherein the charging/discharging units are mounted in the cabinet in a stacked structure,
the power supply device is arranged on an upper or lower layer of the charging/discharging units, and
the power transmission device includes:
a main busbar, one side of which is connected to the output terminal of the power supply device and the other side is formed to extend upward; and
a plurality of sub busbars, one side of which is connected to the main busbar and the other side is extended horizontally and connected to each of the input/output terminals of the charging/discharging units, respectively.

5. The battery charge and discharge system of claim 1, wherein the at least two of the plurality of charging/discharging units are simultaneously charged according to the same charge profile or simultaneously discharged according to the same discharge profile.

6. The battery charge and discharge system of claim 1, wherein the plurality of charge/discharge units are classified into a first group and a second group,
when the first group operates in charge mode, the second group operates in discharge mode, and
when the first group operates in discharge mode, the second group operates in charge mode.

7. The battery charge and discharge system of claim 6, wherein power discharged from a group operating in the discharge mode is supplied to a group operating in the charge mode through the power transmission device.

8. The battery charge and discharge system of claim 7, wherein the power supply device adjusts power output to the power transmission device side in response to power discharged from the group operating in the discharge mode.

9. A control apparatus of a battery charge/discharge system including a plurality of charging/discharging units, a power supply device, and a power transmission device electrically connecting the power supply device and the plurality of charging/discharging units, the control apparatus comprising:
at least one processor; and
a memory configured to store at least one instruction executed by the at least one processor,
wherein the at least one instruction includes:
an instruction to classify the plurality of charging/discharging units into a first group and a second group;
an instruction to set the first group to a charge mode and to set the second group to a discharge mode; and
an instruction to control the charging/discharging units included in the first group to be charged with power simultaneously supplied from the power supply device through the power transmission device.

10. The control apparatus of a battery charge/discharge system of claim 9, wherein the instruction to control the charging/discharging units to be charged includes:
an instruction to control the charging/discharging units included in the first group to be simultaneously charged according to the same charge profile.

11. The control apparatus of a battery charge/discharge system of claim 9, wherein the at least one instruction further includes:
an instruction to control the charging/discharging units included in the second group to be discharged simultaneously according to the same discharge profile.

12. The control apparatus of a battery charge/discharge system of claim 9, wherein the at least one instruction further includes:
an instruction to adjust the power output from the power supply device to the power transmission device in response to the power discharged from the second group.

13. The control apparatus of a battery charge/discharge system of claim 9, wherein the at least one instruction further includes:
an instruction to switch the first group to a discharge mode and to switch the second group to a charge mode when the charge process of the first group is completed and the discharge process of the second group is completed.

14. A control method of a battery charge/discharge system including a plurality of charging/discharging units, a power supply device, and a power transmission device electrically connecting the power supply device and the plurality of charging/discharging units, the control method comprising:
classifying the plurality of charging/discharging units into a first group and a second group;
setting the first group to a charge mode and setting the second group to a discharge mode; and
controlling the charging/discharging units included in the first group to be charged with power simultaneously supplied through the power transmission device from the power supply device.

15. The control method of a battery charge/discharge system of claim 14, wherein the controlling the charging/discharging units to be charged includes:
controlling the charging/discharging units included in the first group to be simultaneously charged according to the same charge profile.

16. The control method of a battery charge/discharge system of claim 14, further including:
controlling the charging/discharging units included in the second group to be discharged simultaneously according to the same discharge profile.

17. The control method of a battery charge/discharge system of claim 14, further including:
adjusting the power output from the power supply device to the power transmission device in response to the power discharged from the second group.

18. The control method of a battery charge/discharge system of claim 14, further including:
switching the first group to a discharge mode and to switch the second group to a charge mode, when the charge process of the first group is completed and the discharge process of the second group is completed.
